# EUROPEAN PATENT SPECIFICATION

(11) **EP 0 391 337 B1**
(45) Date of publication and mention of the grant of the patent: **18.11.1998**
(21) Application number: 90106348.7
(22) Date of filing: 03.04.1990
(51) Int. Cl.: H01L 29/744, H01L 29/08

(54) **Gate turn-off thyristor**
Gate Turn-off-Thyristor
Thyristor à blocage par la gâchette

(30) Priority: 04.04.1989 JP 83939/89; 14.09.1989 JP 237119/89
(43) Date of publication of application: 10.10.1990
(73) Proprietor: Hitachi, Ltd., Chiyoda-ku, Tokyo 101 (JP)
(72) Inventor: Odai, Shingo, Hitachi-shi (JP); Sakurada, Shuroku, Katsuta-shi (JP); Ozeki, Toshiyuki, Hitachi-shi (JP); Sato, Yukimasa, Hitachi-shi (JP); Yatsuo, Tsutomu, Hitachi-shi (JP); Shimizu, Yoshiteru, Katsuta-shi (JP); Sanpei, Isamu, Kitaibaraki-shi (JP); Yagishita, Kenji, Hitachiota-shi (JP)
(74) Representative: Beetz & Partner Patentanwälte

(56) References cited:
- EP-A- 22 355
- EP-A- 200 863
- EP-A- 364 354
- DE-A- 3 722 425
- Proceedings of the first International PCIM '88, Tokyo, 8 - 10 December 1988, pages 125 - 133

## Description

The present invention relates to a gate turn-off thyristor (hereinbelow abbreviated to GTO) according to the preamble in the independent claims. Such gate turn-off thyristors are known from EP-A- 0 200 863. In particular, it relates to a GTO provided with an anode shorted emitter structure suitable for a GTO having a pni (n⁻ or p⁻) structure, in which one of intermediate layers consists of a high impurity concentration region and a low impurity concentration region.

A GTO consists of a semiconductor substrate having 4 layers of pnpn, a pair of main electrodes disposed on the two outer layers and a gate electrode disposed on one of the intermediate layers and it is a thyristor, which can be switched-over either from the non-conductive state to the conductive state between the pair of main electrodes (called turn-on) or from the conductive state to the non-conductive state (called turn-off), depending on the polarity of the gate signal applied to the gate electrode. In order to make this kind of GTOs carry out a sure turn-off operation by means of a small gate signal, each GTO has a structure, in which one of the outer layers (e.g. n emitter layer) has elongated regions, each of which is enclosed by the gate electrode, and the number of elongated regions constituting the one outer layer is increased with increasing capacity of the current flowing therethrough. When the principal surface of the semiconductor substrate is rectangular, these elongated regions constituting the one outer layer are so juxtaposed that the longitudinal direction of the regions is parallel to one side of the rectangle and when it is circular, they are so juxtaposed coaxially, disposing the longitudianl direction in the radial direction. In the GTO, in order to intend to improve turn-off characteristics, the pn junction between an intermediate layer other than the intermediate layer, on which the gate electrode is disposed, and the outer layer adjacent thereto is short-circuted by one of the main electrodes. Since this is realized usually on the anode side, this is called anode shorted emitter structure.

In general, in a thyristor having the pnipn structure, it is known that it is useful for reducing the loss and increasing the speed of a high voltage thyristor to construct one of the intermediate layers by a high impurity concentration region and a low impurity concentration region, because the thickness of the one of the intermediate layers can be reduced with respect to a thyristor having a pnpn structure with a same blocking voltage. It is a matter of course that the pnipn structure is applied to the GTO for the same purpose as that for the thyristor. When the pnipn structure is applied to the GTO having the anode shorted emitter structure, there is a problem that the gate signal for turn-on becomes greater, because the short-circuit resistance becomes smaller, with respect to the case where the anode shorted emitter structure is applied to the pnpn structure.

As a prior art technique of the anode shorted emitter structure capable of solving such a problem there is known the technique described e.g. in JP-A-62-186563.

As a prior art technique concerning how to apply such a structure to the pnipn structure having the anode shorted emitter structure there is known a technique described e.g. in PCIM '88 PROCEEDING pp. 125-133.

According to this prior art technique a ring shaped anode short-circuting layer is arranged so as to pass through the central portion of the projection of elongated strip shaped n emitter regions on the anode side.

When the prior art technique is applied to a large capacity GTO, in which a number of n emitter regions are arranged radially in a plurality of ring shapes, the switching operation of different unit GTO elements, each of which is composed of an n emitter region, becomes non-uniform. For this reason it is necessary to regulate the intensity of the anode shorted emitter (hereinbelow called degree of shorted emitter) of the ring shaped anode short layer for every arrangement ring. In the case where the regulation of the degree of shorted emitter is necessary, since carriers pour-in mutually between different arrangement rings, the degree of shorted emitter of the ring shaped anode short layer varies equivalently. When the state of the carriers in a certain ring varies, this gives the other rings influences of the variation described above, varying the operation thereof. For this reason, there is a problem that it is difficult to design the anode shorted emitter structure and that it is difficult to make the switching operation uniform.

EP-A-0 200 863 discloses a semiconductor element comprising thyristor and diode structures. It shows a thyristor comprising 4 staked layers. One of the outer layer consists of a plurality of elongated regions disposed in a radial direction of the semiconductor substrate. The elongated regions are aligned to each other and disposed so as to form an inner and outer ring of elongated regions.

Prior art document DE-OS 37 22 425 discloses a GTO-thyristor comprising a plurality of GTO-thyristor units in a strip-like arrangement. Each thyristor unit comprises an npnp-structure. The p-base layer and n-base layer are provided in common for all GTO-thyristor units. These units are arranged in a plurality of rings. The n-layer on the anode side has n⁺-regions connected through to the anode electrode. These n⁺-regions are disposed below the n-regions of the cathode. The doping profile on the anode side has two stages, namely a n_{B}-part and the above mentioned n⁺-part.

It is the object of the present invention to provide an anode shorted type GTO for which the fluctuation of intensity of the anode shorted structure occurring due to mutual carrier pour-in between adjacent device regions in the GTO is effectively prevented.

This object is solved in accordance with the features of the single claim.

A GTO of related art comprises a semiconductor substrate, which consists of 4 layers between a pair of principal surfaces, between every adjacent two of which a pn unction is formed; one of the intermediate layers consisting of a low impurity concentration region, which is adjacent to the other intermediate layer, and a high impurity concentration region, which is adjacent to one of the outer layers; the other outer layer consisting of a plurality of elongated regions, so that, when the other outer layer is projected on the one outer layer, the one intermediate layer is exposed in one of the principal surfaces so as to enclose the other outer layer; one main electrode ohmic-contacted with the one outer layer and the exposed part of the one intermediate layer; the other main electrode ohmic-contacted with the different regions of the other outer layer; and a gate electrode contacted with the exposed surface of the other intermediate layer so as to enclose the different regions in the other outer layer. The plurality of elongated regions in the other outer layer are arranged in coaxial rings so that the longitudinal direction of each of the regions is in the radial direction and that the high impurity concentration region of the one intermediate layer is exposed on the principal surface, where the one outer layer is exposed, so that when the other outer layer is projected on the one outer layer, the exposed part thereof is located both on the inner periphery side and on the outer periphery side of each of the rings formed by the elongated regions as well as along the longitudinal direction between the elongated regions.

By such a structure the flow of carriers from one of the plurality of coaxial circular arrangement rings formed by the elongated regions on the other outer layer to the adjacent arrangement ring is ejected from the contact portion of the one intermediate layer formed between the adjacent two arrangement rings and the one main electrode to the one main electrode, before they reach the adjacent arrangement ring. For this reason no interferences are produced between different arrangement rings and it is possible to intend to make the switching operation uniform.
Fig. 1 is a partial plan view showing technological background;
Fig. 2 is a cross-sectional view along the line II-II indicated in Fig. 1;
Figs. 3A, 3B, and 3C are schematical cross-sectional views of different embodiments of a GTO ;
Fig. 4 is a partial plan view of another embodiment of the GTO;
Fig. 5 is a partial plan view of an embodiment of the GTO according to the present invention;
Figs. 6A, 6B and 6C are schemes showing outlines of different GTOs; and
Figs. 7A and 7B are schematical cross-sectional views showing still other embodiments of a GTO.

Hereinbelow, GTOs will be explained, referring to the drawings representing the different embodiments.

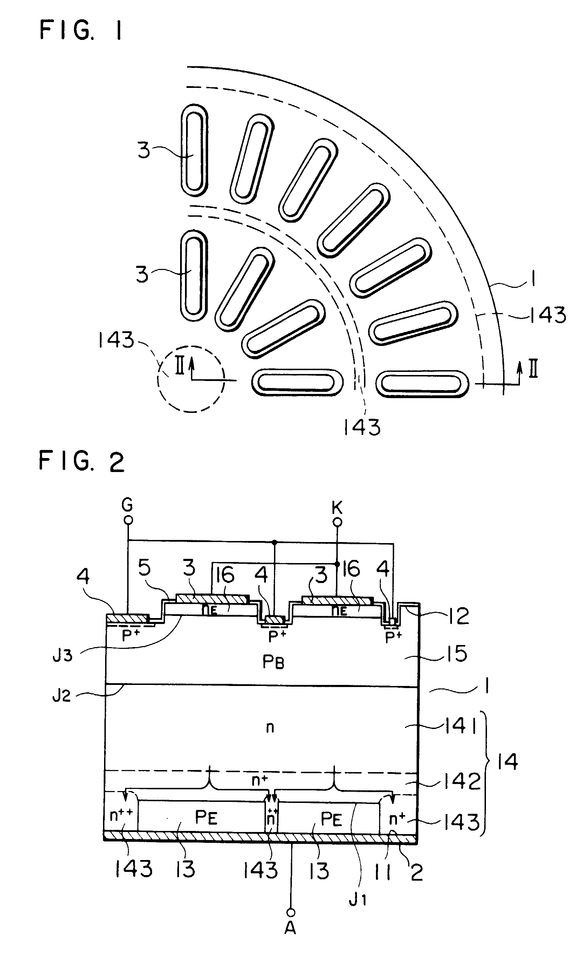

Figs. 1 and 2 show an embodiment of the GTO in which reference numeral 1 is a disk shaped semiconductor substrate; 11 and 12 are a pair of principal surfaces of the semiconductor substrate 1; 13 is one p conductivity type outer layer (p emitter layer, which is adjacent to one of principal surfaces 11; 14 is one n conductivity type intermediate layer (n base layer), which is adjacent to the one outer layer 13 to form a first pn junction J₁; 15 is the p conductivity type other intermediate layer (p base layer), which is adjacent to the one intermediate layer 14 to form a second pn junction J₂; and 16 is the n conductivity type other outer layer (n emitter layer), which is adjacent to the other intermediate layer 15 and the other principal surface 12 to form a third pn junction J₃ with the other intermediate layer 15. The one intermediate layer 14 consists of a first region 141, which is adjacent to the second pn junction J₂; a second region 142 having an impurity concentration higher than that of the first region 141, which second region 142 is adjacent to the first region 141 and a part of the first pn junction J₁, which is parallel to the one principal surface 11; and a third region 143 having an impurity concentration higher than that of the second region 142, which third region 143 is adjacent to the one principal surface 11 and a part of the first pn junction J₁, which is perpendicular to the one principal surface 11. The other outer layer 16 consists of a number of elongated regions, which are so arranged in a double coaxial circular shape that the longitudinal direction is in the radial direction (radial direction of the semiconductor substrate). The other principal surface 12 is etched down in a major part except for the part, where the other outer layer 16 is exposed, so as to be deeper than the third pn junction J₃, and the other intermediate layer 15 is exposed on the surface thus etched down. The places, where the third region 143 of the one intermediate layer 14 is exposed on the one principal surface 11, are located on the inner periphery side and on the outer periphery side of each of the arrangement rings in a double coaxial circular shape on the other outer layer 16 in a form of rings, when the other outer layer 16 is projected on the one principal surface 11. The region on the inner periphery side of the innermost arrangement ring may be a circle. 2 is the one main electrode (anode electrode) ohmic-contacted with the one outer layer 13 and the exposed part of the third region 143 of the one intermediate layer 14 on the one principal surface 11; 3 is the other main electrode (cathode electrode) ohmic-contacted with each of the elongated regions of the other outer layer 16 on the other outer layer 12; 4 is the gate electrode contacted with the other intermediate layer 15 so as to enclose each of the elongated regions of the other outer layer 16 on the other principal surface 12; and 5 is an insulating film covering the exposed part of the third pn junction J₃ and the neighborhood thereof.

The GTO having such a structure brings about effects as follows;
(1) Since there exists a contacting place (anode short place) of the one main electrode 2 and the one intermediate layer 14 between different arrangement rings, no influences due to flowing-out of carriers between the different arrangement rings are produced. For this reason it is easy to design the anode shorted emitter structure and it is possible to realize a GTO having the pnipn structure, by means of which the switching operation is made uniform.
(2) The current path within the second region 142 of the one intermediate layer 14 in the projected part of the other outer layer 16 is long transversally along the first pn junction J₁, as indicated by arrows, and therefore the short-circuit resistance can be great. For this reason, the forward bias of pn junction J₁ becomes large and therefore it is possible to turn-on surely the GTO having the pnipn structure.

The GTO provided with the structure described above can have a high withstand voltage of above 4000 V by increasing the number of arrangement rings and it is possible to control safely and surely a high intensity current of above 2000 A without increasing conduction loss.

Further such a GTO is suitable for the use in an electric power converting apparatus such as an inverter, a converter, etc. and thus it is possible to construct a large capacity electric power converting apparatus.

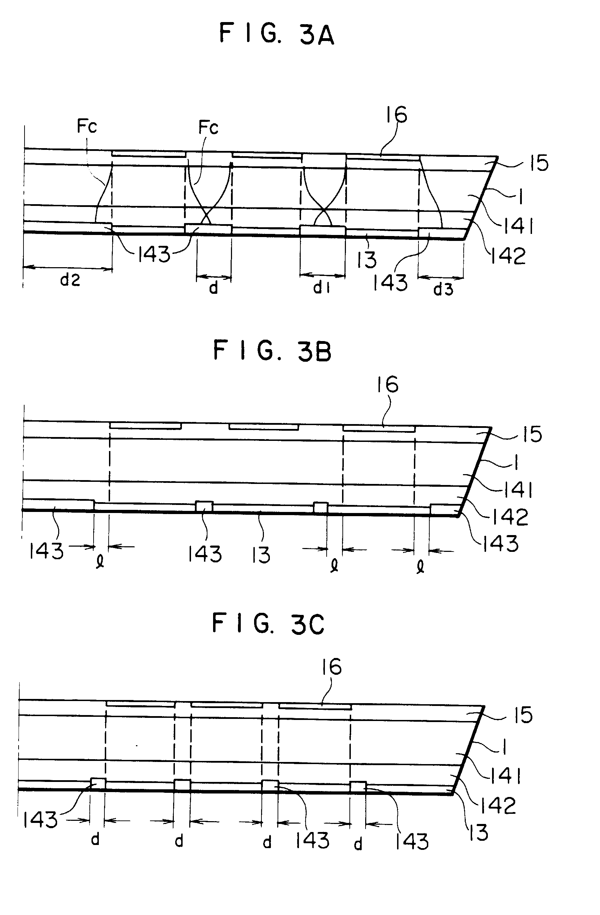

Figs. 3a, 3B and 3C show other embodiments, in which the right half of the semiconductor substrate 1 is indicated, in the case where three arrangement rings are disposed.

The embodiment indicated in Fig. 3A represents the case where the inner periphery side end and the outer periphery side end of the outer layer 16 are in accordance with the respective ends of the third region 143 of the one intermediate layer 14. In this case, the width d₁ of the third region 143 located between different arrangement rings, the width d₂ of the third region 143 at the center part and the width d₃ of the third region 143 at the outer peripheral portion are set so as to be greater than the diffusion length d of the carriers in the one intermediate layer 14.

At the conduction of the GTO the flow Fc of the carriers is enlarged in the transversal direction approximately by an amount of the diffusion length d, as indicated in the figure. It is from the point just below the end portion of the other outer layer 16 to a point distant therefrom approximately by an amount of the diffusion length of the carriers that the anode short place can exhibit the carrier ejecting effect.

Consequently, by this embodiment, in which the width of each of the anode short places is set so as to be greater than this diffusion length of the carriers, it is possible to make the intensity of the short emitter constant.

Fig. 3B shows another embodiment, in which the third region 143, i.e. the anode short place, is formed away from the end portion of each of the arrangement rings by ℓ.

Since, in such a GTO the carrier ejecting effect in the anode short layer at the conduction of the GTO is weakened uniformly in the whole device and in this way it is possible to intend to make the operation uniform and further to enlarge the one outer layer, an effect is obtained that the on-state voltage of the GTO can be lowered.

In the embodiment indicated in Fig. 3C the width d is uniform for all the anode short places including the central portion and the outer peripheral portion and it is set at a value smaller than the carrier diffusion length.

According to this embodiment all the anode short places have the carrier ejecting effect and non-uniformity of the degree of shorted emitter due to the difference in the width of the anode short place is removed so that the degree of shorted emitter is constant throughout the device. In this way it is possible to intend to make the operation uniform.

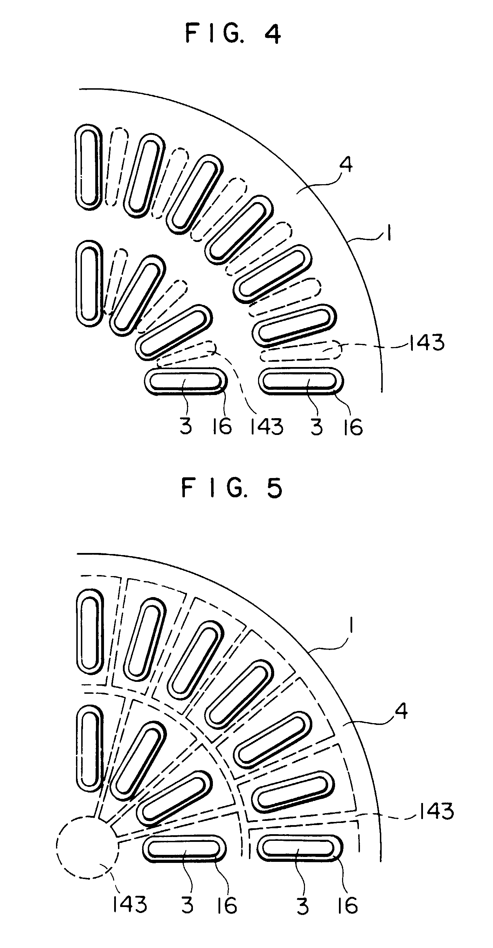

Fig. 4 shows a GTO, in which the third region 143 of the one intermediate layer 14 is formed in the form of a number of elongated regions, each of which is located between adjacent two elongated regions of the other outer layer 16. The same effect as that of the embodiments indicated in Figs. 1 and 2 can be obtained by such a structure.

Fig. 5 illustrates a GTO according to the invention, for which the embodiments indicated in Figs. 1 and 2 are combined with that indicated in Fig. 4. That is, the third region 143 of the one intermediate layer 14 consists of parts, each of which is located in the radial direction between adjacent two elongated regions of the other outer layer 16 and ring-shaped parts on the inner and the outer periphery side of each of the arrangement sings, which are assembles of the elongated regions (the inner most part may be a circle). The two kinds of the parts may be either connected or separated.

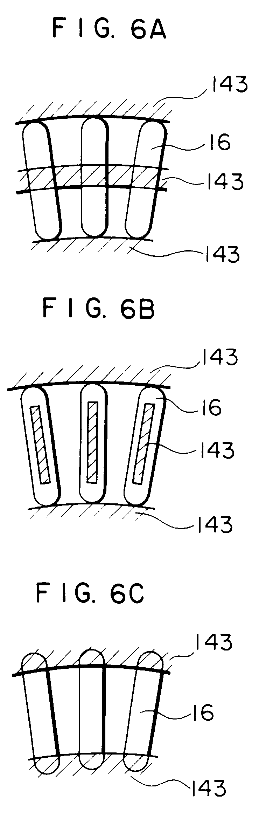

Figs. 6A, 6B and 6C show other GTOs, in which only the relation between the other outer layer 16 and the third region 143 of the one intermediate layer 14 is indicated. In the example indicated in Fig. 6A, coaxial circular parts of the third regions 143 are disposed not only on the inner and the outer periphery side of each of the arrangement rings, which are assemblies of the elongated regions of the other outer layer 16 but also just below them, while in the example indicated in Fig. 6B there are disposed elongated parts of the third region 143 aligned to the longitudinal direction of the elongated regions of the other outer layer 16 below them. Finally, in the example indicated in Fig. 6C the parts of the third region 143 disposed on the inner and the outer periphery side of the arrangement rings are located so as to be partially superposed on the arrangement rings. In all of these embodiments, since parts of the third regions 143, i.e. anode short places, are disposed just below the arrangement rings, it is possible to regulate independently the degree of short-circuit for different arrangement rings.

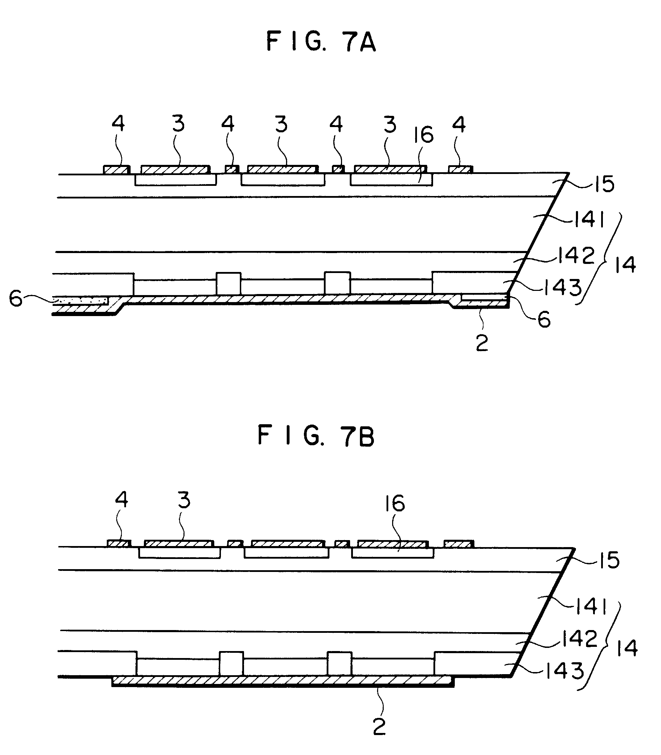

Figs. 7A and 7B show examples, in which the contact area between the parts of the third region 143 located on the innermost and the outermost periphery side of the arrangement rings and the one main electrode 2 is small for the purpose of making the intensity of the short emitter uniform in the whole GTO device. The contact area is reduced in Fig. 7A by interposing an insulating film 6 at a part between the third region 143 and the one main electrode 2 and in Fig. 7B by disposing the one main electrode 2 not on the whole surface of the one principal surface 11, but on the part except for the part, where the insulating film 6 is disposed in Fig. 7A. The effect of the anode shorted emitter increases with increasing contact area between the third region 143 and the one main electrode 2. The contact area is large on the innermost and the outermost periphery side of the arrangement rings and therefore the degree of shorted emitter is not uniform on the whole of the semiconductor substrate. The degree of short-circuit can be made uniform on the whole of the semiconductor substrate by reducing the contact area between the third region on the innermost and the outermost periphery side of the arrangement rings and the one main electrode, as described in this embodiment.

Although above, the present invention has been explained by indicating several embodiments as representative examples, the present invention is not restricted thereto, but various modifications can be made within the scope of the appending claims.

As described above, according to the present invention, since it is possible to make the degree of shorted emitter on the anode side uniform on the whole GTO device and to facilitate the regulation of the degree of short-circuit, improvement in the switching characteristics of the GTO can be obtained.

## Claims

1. A gate turn-off thyristor comprising:
- a disk-shaped semiconductor substrate having a pair of principal surfaces (11, 12) located so as to be opposite to each other;
- one outer layer (13), of first conductivity type consisting of at least two concentric, circular parts which are adjacent to one of said principal surfaces;
- one intermediate layer (14) of second conductivity type, which is adjacent to said one outer layer to form a first pn junction therewith,
- another intermediate layer (15) of first conductivity type, which is adjacent to said one intermediate layer and the other principal surface to form a second pn junction with said one intermediate layer, and
- another outer layer (16) of second conductivity type adjacent to said other intermediate layer and the other principal surface to form a third pn junction with said other intermediate layer, said other outer layer consisting of a plurality of elongated regions each of them being substantially disposed in a radial direction and the entirety being arranged in concentric rings,
said one intermediate layer (14) consisting of
- a first region (141) which is adjacent to said second pn junction,
- a second region (142) having an impurity concentration higher than that of said first region, which is adjacent to said first region and that part of the first pn junction, that is parallel to said one principal surface, and
- a third region (143) having an impurity concentration higher than that of said second region, which is adjacent to said second region and said one principal surface, parts of which are located such that their projection on the other principal surface is located on both sides in the longitudinal direction of each of said elongated regions
the thyristor further comprising
- one main electrode (2) ohmic-contacted with said one outer layer and said third region of said one intermediate layer on said one principal surface of said semiconductor substrate;
- another main electrode (3) ohmic-contacted with said elongated regions of said other outer layer on said other principal surface of said semiconductor substrate;
- a gate electrode (4) contacted with said other intermediate layer so as to enclose each of said elongated regions of said other outer layer on said other principal surface of said semiconductor substrate;
**characterized** in that
said third region of said one intermediate layer has parts located such that their projections on the other principal surface are located between different elongated regions of said other outer layer, alined to their respective longitudinal direction and not located within said other outer layer (16) in order to make the switching operation of the thyristor uniform.

## Patentansprüche

1. Gate-turn-off-Thyristor, mit:
- einem scheibenförmigen Halbleitersubstrat mit zwei Hauptoberflächen (11, 12), die einander gegenüber angeordnet sind;
- einer äußeren Schicht (13) des ersten Leitfähigkeitstyps, die aus zumindest zwei konzentrischen, kreisförmigen Teilen besteht, die an einer der Hauptoberflächen anliegen;
- einer Zwischenschicht (14) des zweiten Leitfähigkeitstyps, die an der einen äußeren Schicht anliegt und mit ihr einen ersten pn-Übergang bildet,
- einer weiteren Zwischenschicht (15) des ersten Leitfähigkeitstyps, die an der einen Zwischenschicht und an der anderen Hauptoberfläche anliegt, um mit der einen Zwischenschicht einen zweiten pn-Übergang zu bilden, und
- einer anderen äußeren Schicht (16) des zweiten Leitfähigkeitstyps, die an der anderen Zwischenschicht und der anderen Hauptoberfläche anliegt, um mit der anderen Zwischenschicht einen dritten pn-Übergang zu bilden, wobei die andere äußere Schicht aus mehreren länglichen Regionen besteht, die jeweils im wesentlichen in radialer Richtung und insgesamt in konzentrischen Ringen angeordnet sind,
wobei die eine Zwischenschicht (14) aufweist
- eine erste Region (141), die am zweiten pn-Übergang anliegt,
- eine zweite Region (142), die eine Dotierungskonzentration höher als diejenige der ersten Region hat und die an der ersten Region und demjenigen Teil des ersten pn-Übergangs anliegt, der parallel zur einen Hauptoberfläche ist, und
- eine dritte Region (143), deren Dotierungskonzentration höher ist als diejenige der zweiten Region und die an der zweiten Region und der einen Hauptoberfläche anliegt, wobei Teile von ihr so angeordnet sind, daß deren Projektion auf die andere Hauptoberfläche sich in Längsrichtung beiderseits der länglichen Regionen befindet,
wobei der Thyristor außerdem aufweist
- eine Hauptelektrode (2), die mit der einen äußeren Schicht und der dritten Region der einen Zwischenschicht auf der einen Hauptoberfläche des Halbleitersubstrats ohmisch kontaktiert ist;
- eine weitere Hauptelektrode (3), die mit den länglichen Regionen der anderen äußeren Schicht auf der anderen Hauptoberfläche des Halbleitersubstrats ohmisch kontaktiert ist;
- eine Gate-Elektrode (4), die die andere Zwischenschicht so kontaktiert, daß die länglichen Regionen der anderen äußeren Schicht auf der anderen Hauptoberfläche des Halbleitersubstrats eingeschlossen sind,
dadurch gekennzeichnet, daß
der dritte Bereich der einen Zwischenschicht Teile hat, die so angeordnet sind, daß ihre Projektionen auf die andere Hauptoberfläche zwischen unterschiedlichen länglichen Regionen der anderen äußeren Schicht liegen, zu den jeweiligen Längsrichtungen ausgerichtet sind und nicht innerhalb der anderen äußeren Schicht (16) liegen, um den Schaltvorgang des Thyristors gleichförmig zu machen.

## Revendications

1. Thyristor à blocage par la gâchette, comprenant :
- un substrat semi-conducteur en forme de disque possédant une paire de surfaces principales (11, 12) situées de façon à être opposées l'une à l'autre;
- une première couche externe (13) d'un premier type de conductivité constituée d'au moins deux parties circulaires concentriques qui sont adjacentes à une desdites surfaces principales;
- une première couche intermédiaire (14) d'un second type de conductivité qui est adjacente à ladite première couche externe pour former avec celle-ci une première jonction pn;
- une autre couche intermédiaire (15) du premier type de conductivité qui est adjacente à ladite première couche intermédiaire et à l'autre surface principale pour former une seconde jonction pn avec ladite première couche intermédiaire; et
- une autre couche externe (16) du second type de conductivité adjacente à ladite autre couche intermédiaire et à l'autre surface principale pour former une troisième jonction pn avec ladite autre couche intermédiaire, ladite autre couche externe étant constituée d'une pluralité de zones allongées, chacune d'elles étant sensiblement disposée dans une direction radiale et la totalité étant agencée en anneaux concentriques;
ladite première couche intermédiaire (14) comprenant :
- une première zone (141) qui est adjacente à ladite seconde jonction pn;
- une seconde zone (142) possédant une concentration en impuretés supérieure à celle de la première zone, qui est adjacente à ladite première zone et à la partie de la première jonction pn qui est parallèle à ladite surface principale; et
- une troisième zone (143) présentant une concentration en impuretés supérieure à celle de ladite seconde zone, qui est adjacente à ladite seconde zone et à ladite surface principale, dont des parties sont situées de telle façon que leur projection sur l'autre surface principale soit située de chaque côté, en direction longitudinale, de chacune desdites zones allongées;
le thyristor comprenant, de plus :
- une électrode principale (2) en contact ohmique avec ladite première couche externe et ladite troisième zone de ladite première couche intermédiaire sur ladite surface principale dudit substrat semi-conducteur;
- une autre électrode principale (3) en contact ohmique avec lesdites zones allongées de ladite autre couche externe sur ladite autre surface principale dudit substrat semi-conducteur;
- une électrode de gâchette (4) en contact avec ladite autre couche intermédiaire de façon à inclure chacune desdites zones allongées de ladite autre couche externe sur ladite autre surface principale dudit substrat semi-conducteur;
caractérisé en ce que :
ladite troisième zone de ladite première couche intermédiaire possède des parties situées de telle façon que leurs projections sur l'autre surface principale soient situées entre différentes zones allongées de ladite autre couche externe, alignées dans leur direction longitudinale respective et en dehors de ladite autre couche externe (16) de façon à rendre uniforme l'opération de commutation du thyristor.
